# EUROPÄISCHE PATENTSCHRIFT

(11) **EP 4 558 834 B1**
(45) Veröffentlichungstag und Bekanntmachung des Hinweises auf die Patenterteilung: **08.07.2026**
(21) Anmeldenummer: 23744809.7
(22) Anmeldetag: 21.07.2023
(51) Int. Cl.: G01R 1/067

(54) **PRÜFSTIFTVORRICHTUNG**
TEST PROBE DEVICE
DISPOSITIF DE SONDE DE TEST

(30) Priorität: 21.07.2022 DE 202022104119 U
(43) Veröffentlichungstag der Anmeldung: 28.05.2025
(73) Patentinhaber: Feinmetall Gesellschaft mit beschränkter Haftung, 71083 Herrenberg (DE)
(72) Erfinder: IHLE, Arno, 71229 Leonberg (DE); KIRN, Johannes, 72202 Nagold (DE)
(74) Vertreter: Gleiss Große Schrell und Partner mbB
(86) Internationale Anmeldenummer: PCT/EP2023/070253
(87) Internationale Veröffentlichungsnummer: WO 2024/018047

(56) Entgegenhaltungen:
- DE-U1- 202019 106 237
- DE-U1- 202019 106 239
- DE-U1- 202020 102 142
- DE-U1- 202022 101 265

## Beschreibung

Die Erfindung betrifft eine Prüfstiftvorrichtung zum elektrischen Kontaktieren eines insbesondere mehrpoligen Kontaktpartners, mit einem Trägerteil, das zumindest eine Führungsöffnung aufweist, und mit zumindest einem Prüfstift, der in der Führungsöffnung längsverschieblich gelagert ist, wobei der Prüfstift ein zylinderförmiges Gehäuse aufweist, in welchem ein oder mehrere, insbesondere stiftförmige Kontaktelemente nebeneinander liegend angeordnet sind, die jeweils ein Kontaktende zum Kontaktieren des Kontaktpartners aufweisen, wobei das Gehäuse einen in der Führungsöffnung längsverschieblich gelagerten Führungsabschnitt und einen davon beabstandeten Kontaktabschnitt aufweist, und wobei die Kontaktenden dem Kontaktabschnitt zugeordnet sind, wobei zwischen dem Kontaktabschnitt und dem Trägerteil ein Federelement vorgespannt und an dem Gehäuse an den Führungsabschnitt anschließend, auf der von dem Federelement abgewandten Seite des Trägerteils, ein Axialanschlag ausgebildet ist, der mit dem Trägerteil entgegen der Federkraft zusammenwirkt, wobei ein maximaler Dreh- und/oder Kippwinkel des Prüfstifts um seine Längsachse, insbesondere seine Längsmittelachse oder eine außermittige Längsachse, relativ zu dem Trägerteil durch die Führungsöffnung und den Führungsabschnitt begrenzt ist, wozu die Führungsöffnung und der Führungsabschnitt jeweils einen Querschnitt mit wenigstens einer Geraden, insbesondere jeweils einen mehreckigen Querschnitt aufweisen, und wobei Führungsabschnitt und Führungsöffnung derart ausgebildet sind, dass der Prüfstift in zumindest einer Schiebeposition relativ zu dem Träger taumeln, also mit seiner Längsachse relativ zur Längsachse des Trägerteils beziehungsweise der Führungsöffnung verschwenken kann.

Prüfstiftvorrichtungen der eingangs genannten Art sind aus dem Stand der Technik bereits bekannt. Eine gattungsgemäße Prüfstiftvorrichtung ist beispielsweise in der Offenlegungsschrift DE 20 2019 106 239 U1 beschrieben. Durch eine Anpassung des Außenquerschnitts des Gehäuses des Prüfstifts an den Innenquerschnitt der Trägerteils, dort als Außengehäuse bezeichnet, wird erreicht, dass ein maximaler Kipp- oder Verdrehwinkel des innenliegenden Prüfstifts relativ zu einem Trägerteil begrenzt ist. Dabei wird diese Begrenzung in Abhängigkeit von einer Schiebestellung des Prüfstifts in seiner Längserstreckung relativ zu dem Trägerteil verändert. Wird die Prüfstiftvorrichtung zum Kontaktieren eines Kontaktpartners eingesetzt, so wird die Prüfstiftvorrichtung mit dem Kontaktende des Prüfstifts auf den Kontaktpartner aufgedrückt.

Dadurch wird das Federelement elastisch verformt und der Prüfstift relativ zu dem Trägerteil verschoben. Bei diesem Einfedern des Prüfstifts in dem Trägerteil verschiebt sich der Prüfstift zu dem Trägerteil derart, dass nunmehr in der Führungsöffnung ein Bereich des Führungsabschnitts des Prüfstifts liegt, der einen im Vergleich zur Ausgangsstellung anderen Außenquerschnitt aufweist, der einen größeren maximalen Kipp- oder Verdrehwinkel zulässt. Dadurch kann der Prüfstift im eingefederten Zustand weiter verdreht werden als im ausgefederten Zustand. Aus der Offenlegungsschrift EP 2 666 022 B1 ist eine ähnliche Prüfstiftvorrichtung bekannt. Auch aus den Druckschriften DE 20 2020 102 142 U1, DE 20 2022 101 265 U1 und DE 20 2019 106 237 U1 sind Prüfstiftvorrichtungen bereits bekannt.

Der vorliegenden Erfindung liegt die Aufgabe zugrunde, eine verbesserte Prüfstiftvorrichtung zu schaffen, die insbesondere eine geringe Fehleranfälligkeit bei der Durchführung von Kontaktierungen von Kontaktpartnern aufweist, geringen Verschleiß gewährleistet und bauraumsparend ausgebildet ist.

Die der vorliegenden Erfindung zugrunde liegende Aufgabe wird durch eine Prüfstiftvorrichtung mit den Merkmalen des Anspruchs 1 gelöst. Diese hat den Vorteil, dass die Verdrehbarkeit des Drehstifts relativ zu dem Trägerteil unabhängig von der Schiebeposition des Prüfstifts stets gleich ist beziehungsweise gleich begrenzt ist. Ein maximal zugelassener Drehwinkel des Prüfstifts zu dem Trägerteil ist somit über die gesamte Längserstreckung beziehungsweise über den gesamten Verschiebeweg des Prüfstifts in dem Trägerteil konstant. Dadurch wird vermieden, dass der Prüfstift unnötig weit bei einer Kontaktierung des Kontaktpartners verdreht wird, wobei diese Verdrehung bei der Zurückstellung des Prüfstifts in die Ausgangsstellung durch das Federelement entsprechend weit wieder zurückbewegt werden müsste, mit den entsprechenden Folgen für den Verschleiß der Prüfstiftvorrichtung. Sollte sich der Prüfstift beispielsweise aufgrund von Haftreibungen nicht automatisch in den Bereich mit stärker begrenztem Drehwinkel zurückbewegen lassen, so kann er verklemmen und würde eine weitere Verwendung der Prüfstiftvorrichtung verhindern. Durch den konstanten maximalen Drehwinkel der vorliegenden Erfindung wird sicher verhindert, dass Probleme beim Übergang des Prüfstifts vom Bereich mit erhöhtem maximalen Drehwinkel zu reduziertem maximalen Drehwinkel entstehen können. Dadurch ist die Prüfstiftvorrichtung weniger fehleranfällig und auch mit weniger Verschleiß behaftet. Stattdessen wird bei der vorliegenden Prüfstiftvorrichtung das Taumelspiel des Prüfstifts relativ zu dem Trägerteil in vorteilhafter Weise in der Ausgangsstellung, also im ausgefederten Zustand des Prüfstifts, reduziert. Unter einem Taumeln des Prüfstifts relativ zum Trägerteil wird ein Verschwenken oder Verkippen des Prüfstifts beziehungsweise einer Mittellängsachse des Prüfstifts relativ zu einer Längsachse der Führungsöffnung beziehungsweise des Trägerteils verstanden. Durch die Taumelbewegung des Prüfstifts ist bei der Kontaktierung des Kontaktpartners das Ausgleichen von lateralem Versetzen zwischen Kontaktpartner und Trägerteil ermöglicht, sodass Ungenauigkeiten bei der Positionierung der Prüfstiftvorrichtung relativ zu dem Kontaktpartner sicher ausgeglichen werden können. Dies ist sowohl von Vorteil bei Prüfstiften, die nur ein Kontaktelement aufweisen, als auch bei Prüfstiften die mehrere Kontaktelemente aufweisen. Der Axialanschlag wirkt im ausgefederten Zustand der Kraft des Federelements entgegen und verhindert, dass der Prüfstift durch das Federelement aus dem Trägerteil herausbewegt werden kann. Er definiert somit den maximalen Ausfederweg des Prüfstifts relativ zu dem Trägerteil. Durch die erfindungsgemäße Ausführungsform der Prüfstiftvorrichtung wird erreicht, dass dieses Taumelspiel in vorteilhafter Art und Weise in der Ausgangsstellung, also im ausgefederten Zustand des Prüfstifts, reduziert wird, sodass der Prüfstift auf einfache Art und Weise eine vorgegebene Ausgangsstellung in Bezug auf die Taumelbewegung gelangt. Die Verdrehbarkeit des Prüfstifts wird dabei in vorteilhafter Weise nicht beeinflusst, sodass eine Verdrehung des Prüfstifts bereits im ersten Kontaktmoment mit dem Kontaktpartner erfolgt, noch bevor eine Taumelbewegung zugelassen ist. Dadurch ist ein sicheres Zusammenführen von Prüfstift und Kontaktpartner jederzeit gewährleistet. Erfindungsgemäß wird dies dadurch erreicht, dass zwischen dem Führungsabschnitt des Prüfstifts und dem Axialanschlag ein Übergangsabschnitt ausgebildet ist. Der Übergangsabschnitt führt von dem Führungsabschnitt zu dem Axialanschlag. Erfindungsgemäß weist der Übergangsabschnitt einen kreisförmigen Querschnitt auf, dessen Durchmesser höchstens so groß wie die kleinste lichte Weite oder Diagonale des Querschnitts der Führungsöffnung und kleiner als die größte Diagonale des Querschnitts des Führungsabschnitts ist, sodass der Übergangsabschnitt über seinen Umfang gesehen den Führungsabschnitt nur bereichsweise radial überragt. Damit ist der kreisförmige Übergangsabschnitt bereichsweise größer als der Führungsabschnitt, im Querschnitt gesehen. Dadurch, dass der Führungsabschnitt im Querschnitt wenigstens eine Gerade aufweist, die eine Sekante zu einer Kreisform bildet, weist der Querschnitt im Bereich der Geraden eine kleinere Breite auf als in einem benachbarten Bereich, sodass durch die Sekante oder Gerade der Querschnitt reduziert wird. Weil der Querschnitt des Führungsabschnitts kleiner sein muss als der Querschnitt der Führungsöffnung, und der Übergangsbereich einen Durchmesser aufweist, der höchstens so groß ist wie die kleinste lichte Weite oder Diagonale des Querschnitts der Führungsöffnung und größer als die kleinste Breite des Querschnitts des Führungsabschnitts, liegt der kreisförmige Übergangsabschnitt radial gesehen zwischen der Geraden des Querschnitts des Führungsabschnitts und dem inneren Umfang des Querschnitts der Führungsöffnung. Dadurch wirkt der Übergangsabschnitt als Taumelzentrierung, ohne jedoch dabei die Drehbarkeit oder Verdrehbarkeit des Prüfstifts relativ zu dem Trägerteil beeinträchtigen. Dadurch, dass die Taumelzentrierung dem Axialanschlag zugeordnet ist, liegen sowohl Axialanschlag und Taumelzentrierung nah beieinander und an der dem Federelement abgewandten Seite des Trägerteils. Zentriermittel innerhalb der Führungsöffnung, auf der dem Federelement zugewandten Seite der Führungsöffnung, sind somit nicht notwendig. Dadurch kann die Führungsöffnung selbst einfach hergestellt werden, wodurch Kosten und Aufwand gespart werden. Darüber hinaus verkürzt sich damit die maximal notwendige Länge der Führungsöffnung erheblich, wodurch die erfindungsgemäße Prüfstiftvorrichtung insgesamt besonders bauraumsparend - in axialer beziehungsweise in Längsverschiebungsrichtung gesehen - herstellbar ist.

Gemäß einer bevorzugten Weiterbildung der Erfindung weist der Übergangsabschnitt in zumindest einem den Führungsabschnitt überragenden Bereich eine Einführschräge auf. Durch die Einführschräge wird ein abrupter Übergang von dem Führungsabschnitt zu der Taumelbegrenzung vermieden. Vielmehr wird dadurch ein sanftes und verschleißarmes Eindringen des Übergangsabschnitts in die Führungsöffnung sowie eine Zentrierung des Prüfstifts gewährleistet. Je nach Länge der Axialerstreckung des Übergangsabschnitts kann die Einführschräge länger oder kürzer ausfallen. Vorzugsweise ist der Übergangsabschnitt im Vergleich zum Führungsabschnitts deutlich kürzer ausgebildet, wobei die Einführschräge bevorzugt in etwa die Hälfte der Länge des Übergangsabschnitt aufweist. Durch die Kreisform des Übergangsabschnitts bildet die Einführschräge eine Kreisabschnittsfläche aus, die von dem Führungsabschnitt zu dem Außendurchmesser beziehungsweise Durchmesser des Übergangsabschnitt führt. Sinnvollerweise ist die Einführschräge in dem den Führungsabschnitt radial überragenden Bereich ausgebildet und führt somit insbesondere und bevorzugt von der Geraden - im Querschnitt des Führungsabschnitts gesehen - zu dem Übergangsabschnitt. Vorzugsweise ist jeder Geraden des Führungsabschnitts eine entsprechende Einführschräge zugeordnet, die zudem zu dem ihre Gerade überragenden Übergangsabschnitt führt. Die jeweilige Gerade im Querschnitt des Führungsabschnitts bildet über die Längserstreckung des Führungsabschnitts gesehen eine Führungsfläche aus, die insbesondere mit einer Führungsgegenfläche der Führungsöffnung zusammenwirkt, um als Verdrehbegrenzung zu dienen.

Vorzugsweise führt die Einführschräge von dem Führungsabschnitts in den Übergangsabschnitt hinein ansteigend, also mit zunehmendem Abstand zur Längsmittelachse des Prüfstifts, und somit von einer Führungsfläche zu dem dazu größeren Übergangsabschnitt beziehungsweise zu dem die Führungsfläche überragende Führungsabschnitt.

Vorzugsweise weist der Führungsabschnitt einen quadratischen Querschnitt auf. Somit ist der Führungsabschnitt im Querschnitt durch vier oder zumindest vier Geraden und somit durch vier Führungsflächen gekennzeichnet, die die gleiche Länge und Breite aufweisen. Durch den quadratischen Querschnitt wird gewährleistet, dass der Prüfstift in mehreren Drehstellungen, jeweils um 90 Grad verdreht, in das Trägerteil beziehungsweise in die Führungsöffnung des Trägerteils einsetzbar ist. Dadurch ergibt sich zum einen eine leichte Montage und zum anderen wird gewährleistet, dass die Verdrehsicherung beziehungsweise der maximale Drehwinkel unabhängig von der Montageposition des Prüfstifts stets der Gleiche ist.

Vorzugsweise weist die Führungsöffnung alternativ oder zusätzlich einen quadratischen Querschnitt auf. Hierdurch ist ein sicheres Zusammenwirken mit dem Prüfstift jederzeit gewährleistet. Insbesondere weisen sowohl Führungsabschnitt als auch Führungsöffnung einen quadratischen Querschnitt auf, sodass eine einfache Montage und Verwendung der Prüfstiftvorrichtung gewährleistet sind. Durch den quadratischen Querschnitt weisen sowohl der Führungsabschnitt als auch die Führungsöffnung jeweils vier Führungsflächen auf, die als Verdrehbegrenzung miteinander wirken. Gleichzeitig wirken die Führungsflächen als Lagerflächen für die Längsverschiebung des Prüfstifts relativ zu dem Trägerteil.

Gemäß einer bevorzugten Weiterbildung der Erfindung weist der Führungsabschnitt im Querschnitt gesehen angefaste Ecken auf. Somit treffen die Führungsflächen nicht direkt in einem Winkel von 90 Grad aufeinander, sondern werden durch angefaste Ecken miteinander verbunden. Durch die angefaste Ecken wird der Verschleiß der Prüfstiftvorrichtung weiter reduziert und die Verdrehbarkeit des Prüfstifts, zumindest im Rahmen des zugelassenen maximalen Drehwinkels, verbessert. Vorzugsweise sind die die angefasten Ecken im Querschnitt bildenden Geraden kürzer ausgebildet als die Geraden, die den jeweiligen Führungsabschnitt definieren.

Gemäß einer bevorzugten Weiterbildung der Erfindung weist die Führungsöffnung im Querschnitt gesehen abgerundete Ecken auf. Durch die abgerundeten Ecken wird in der Führungsöffnung dem Prüfstift beziehungsweise dem Gehäuse des Prüfstifts ein Freiraum gegeben, in welcher eine Kollision des Führungsabschnitts mit dem Trägerteil verhindert ist. Insbesondere lassen sich in diesem Bereich die angefasten Ecken des Führungsabschnitts in vorteilhafter Weise positionieren und sowohl in Längserstreckung als auch in Drehrichtung bewegen. Dadurch werden Verschleiß und Fehleranfälligkeit reduziert. Die Ausbildung des Querschnitts des Führungsabschnitts als insbesondere vierkant mit abgerundeten Ecken ermöglicht ein Maximum an innerem Bauraum bei minimalen Außenabmessungen des Prüfstifts.

Vorzugsweise ist der maximale Drehwinkel oder Kippwinkel, um welchen der Prüfstift um seine Längsachse, insbesondere Mittellängsachse oder außermittige Längsachse, relativ zu dem Trägerteil verdrehbar ist, unabhängig von einer Längsverschiebung des Prüfstifts in dem Trägerteil begrenzt. Somit ist der Prüfstift immer um den gleichen maximalen Kipp- oder Drehwinkel relativ zu dem Trägerteil kipp- oder verdrehbar, unabhängig davon, in welcher Schiebeposition sich der Prüfstift in dem Trägerteil befindet.

Gemäß einer bevorzugten Weiterbildung der Erfindung weist die Führungsöffnung an ihrem von dem Axialanschlag abgewandten Ende eine den Querschnitt verjüngende Stufe auf, wobei die Gesamtlänge von Führungsabschnitt und Übergangsabschnitt größer ist als der Abstand der Stufe zum freien, dem Axialanschlag zugewandten Ende der Führungsöffnung. Dadurch ist gewährleistet, dass zur eindeutigen Positionierung des Prüfstifts im ausgefederten Zustand allein der Axialanschlag verantwortlich ist, der sich an den Übergangsabschnitt anschließt. Insbesondere kann dadurch auf einen in der Führungsöffnung liegenden weiteren Axialanschlag verzichtet werden und wird bevorzugt verzichtet. Dadurch ist ein kompakter und kostengünstiger Aufbau der Prüfstiftvorrichtung ermöglicht.

Gemäß einer bevorzugten Weiterbildung der Erfindung weist das Gehäuse im Bereich des Axialanschlags eine Querbohrung mit einem Gewinde für eine Halteschraube auf, mittels welcher Anschlusskabel in dem Gehäuse befestigbar sind. Die Anschlusskabel dienen insbesondere dazu, das oder die Kontaktelemente elektrisch zu kontaktieren. Durch die Halteschraube sind die Anschlusskabel in dem Gehäuse arretierbar, sodass eine Zugentlastung der Anschlusskabel gewährleistet ist, die verhindert, dass eine auf ihre Anschlusskabel wirkende Zugkraft sich auf die Kontaktstelle zwischen Anschlusskabel und Kontaktelement auswirkt. Dadurch wird die Betriebssicherheit der Prüfstiftvorrichtung optimiert.

Gemäß einer weiteren vorteilhaften Weiterbildung der Erfindung weist der Kontaktabschnitt des Gehäuses an seinem freien Ende zumindest eine Einführschräge zur Zentrierung des Kontaktpartners auf. Durch die Einführschräge wird gewährleistet, dass sich der Prüfstift automatisch beim Kontaktieren des Kontaktpartners zu dem Kontaktpartner ausrichtet. Insbesondere wird durch die Einführschräge die Taumelbewegung des Prüfstifts relativ zu dem Trägerteil bewirkt. Hierdurch ist ein sicheres und einfaches Kontaktieren des Kontaktpartners gewährleistet.

Weiterhin ist bevorzugt vorgesehen, dass das Kontaktende des jeweiligen Kontaktelements vollständig innerhalb des Gehäuses, insbesondere zurückgesetzt zu der freien Stirnseite des Kontaktabschnitts, liegt. Damit wird insbesondere gewährleistet, dass eine Zentrierung des Prüfstifts zu dem Kontaktpartner bereits einsetzt, bevor das Kontaktelement den Kontaktpartner selbst erreicht. Dadurch ist ein sicheres Zusammenführen von Kontaktelement und Kontaktpartner gewährleistet, sodass auch bei einer hohen Anzahl von Prüfvorgängen stets ein sicheres Kontaktieren gewährleistet ist.

Gemäß einer bevorzugten Weiterbildung der Erfindung weist das Trägerteil eine oder mehrere Befestigungsöffnungen beabstandet zu der Führungsöffnung auf. In die Befestigungsöffnungen können beispielsweise Befestigungsschrauben eingeführt werden, mittels welcher das Trägerteil an einem Träger, der optional mehrere derartige Trägerteile trägt, befestigt werden kann.

Vorzugsweise weist das Trägerteil mehrere Führungsöffnungen auf, in denen jeweils ein Prüfstift montiert oder montierbar ist. Dadurch lassen sich mehrere Prüfstifte an einem Trägerteil montieren, wobei die Führungsöffnung und die Prüfstifte insbesondere wie obenstehend beschrieben ausgebildet sind. Dadurch ist jeder Prüfstift unabhängig von den weiteren Prüfstiften derselben Prüfstiftvorrichtung im Rahmen des zugelassenen maximalen Drehwinkels verdrehbar und im Rahmen der zulässigen Taumelbewegung verschwenkbar. Hierdurch ergibt sich, dass mit der Prüfstiftvorrichtung auch mehrere Kontaktpartner gleichzeitig sicher kontaktiert werden können.

Weiterhin ist bevorzugt vorgesehen, dass das Trägerteil eine Breite aufweist, die kleiner oder gleich der Breite des Kontaktabschnitts ist. Dadurch überragt das Trägerteil seitlich nicht den Kontaktabschnitt oder den Prüfstift. Dadurch wird erreicht, dass die Prüfstiftvorrichtung insgesamt nur so breit ist, wie der Prüfstift im Bereich des Kontaktabschnitts. Damit können eine Vielzahl derartiger Prüfstiftvorrichtungen nebeneinander an einem Hauptträger angeordnet und der Bauraum optimiert ausgenutzt werden.

Gemäß einer bevorzugten Weiterbildung der Erfindung weist das Gehäuse zwischen dem Führungsabschnitt und dem Kontaktabschnitt einen das eine oder die mehreren Kontaktelemente umgebenden Mantelabschnitt auf, der in dem Trägerteil radial geführt ist. Der sich insbesondere in Verlängerung des Führungsabschnitts erstreckende Mantelabschnitt des Gehäuses ist somit ebenfalls radial in dem Trägerteil geführt, wodurch die Taumelbewegung des Prüfstifts besser einstellbar ist. Dabei ist die Taumelbewegung umso besser einstellbar, umso größer der Abstand zwischen dem geführten Mantelabschnitt und dem Übergangsabschnitt beziehungsweise dem Axialanschlag ist.

Vorzugsweise ist zur Führung des Mantelabschnitts ein Lagerring vorhanden, der zumindest bereichsweise elastisch und/oder plastisch verformbar und zumindest abschnittsweise zwischen dem Mantelabschnitt und dem Trägerteil radial verspannt gehalten ist. Der Lagerring ist somit als Zwischenlager zwischen Trägerteil und Mantelabschnitt vorgesehen, und ist beispielsweise materialtechnisch vorteilhaft ausgebildet, um geringe Reibwerte zu gewährleisten. Durch die elastische und/oder plastische Verformbarkeit des Lagerrings wird ein bevorzugt spielfreies Führen des Mantelabschnitts und damit des Prüfstifts beziehungsweise des Gehäuses in dem Trägerteil gewährleistet, zumindest in dem Bereich, in welchem der Lagerring wirkt. Das Taumelspiel und/oder Drehspiel des Prüfstifts wird im Bereich des Führungsabschnitts hiervon unberührt aufrechterhalten. Durch die elastische Verformbarkeit wird gewährleistet, dass der Lagerring ein Verklemmen und damit ein Arretieren des Gehäuses in einer Schiebestellung verhindert. Bevorzugt ist der Abschnitt der Führungsöffnung, in welchem der Lagerring angeordnet ist, mit einem kreisförmigen Querschnitt ausgebildet, ebenso wie der Mantelabschnitt, so dass im Bereich dieser Lagerstelle eine Drehbewegung des Prüfstifts relativ zu dem Trägerteil nicht beeinträchtigt wird. Dabei ist der Lagerring derart ausgebildet, dass er ein axiales Verschieben des Mantelabschnitts beziehungsweise des Prüfstifts relativ zu dem Trägerteil zulässt und insoweit als Gleitring wirkt oder ausgebildet ist.

Besonders bevorzugt weist der Lagerring eine Einführschräge für das Trägerteil auf, die zum einen die Montage erleichtert und zum anderen bei der Montage durch elastische Verformung des Lagerrings selbst den oben genannten vorteilhaften Spielausgleich ermöglicht. Vorzugsweise ist der Lagerring dazu konisch ausgebildet, sodass sein Außendurchmesser in Einschieberichtung in das Trägerteil hinein abnimmt. Besonders bevorzugt weist der Lagerring einen Lagerringanschlag auf, der die maximale Eindringtiefe des Lagerrings in das Trägerteil begrenzt. So ist der Lagerringanschlag als Axialanschlag ausgebildet, der insbesondere mit dem Trägerteil direkt zusammenwirkt und einen Außendurchmesser aufweist, der größer ist als die Öffnung oder der Abschnitt der Führungsöffnung des Trägerteils, in welcher der Lagerring in das Trägerteil zur Montage eingeschoben wird.

Vorzugsweise weist der Lagerring einen Lagerringanschlag auf, der radial nach Außen vorsteht und zwischen dem Federelement einerseits und dem Trägerteil andererseits gehalten ist. Somit stützt sich das Federelement einendig nicht direkt an dem Trägerteil, sondern an dem Lagerring axial ab, der sich wiederum an dem Trägerteil abstützt. Dadurch ist der Lagerring durch das Federelement stets mit einer in Richtung des Trägerteils wirkenden Vorspannkraft beaufschlagt, die den Lagerring in die den Lagerring aufnehmende Führungsöffnung des Trägerteils eindrückt. Durch die bevorzugte elastische Verformbarkeit des Lagerrings passt er sich optimal an Mantelabschnitt und Trägerteil an, durch die Vorspannkraft wird gewährleistet, dass sich der Gleit- oder Lagerkontakt zu Mantelabschnitt und Trägerteil nie löst, wodurch ein dauerhaft sicherer Betrieb gewährleistet ist. Die Verformbarkeit des Lagerrings ist dabei bevorzugt derart ausgelegt, dass die elastische und/oder plastische Verformung durch die Vorspannkraft des Federelements ausgelöst und aufrechterhalten wird. Ein verformungs- oder verschleißbedingtes Nachlassen der radialen Spannkraft des Lagerrings wird dann durch das permanente Nachschieben in das Trägerteil durch das Federelement kompensiert.

Im Folgenden soll die Erfindung anhand der Zeichnung näher erläutert werden. Dazu zeigen
- Figur 1: eine vorteilhafte Prüfstiftvorrichtung in einer perspektivischen Darstellung,
- Figur 2: die Prüfstiftvorrichtung in einer perspektivischen Längsschnittdarstellung,
- Figur 3: eine perspektivische Darstellung eines Teils eines Gehäuses der Prüfstiftvorrichtung,
- Figur 4: eine perspektivische Längsschnittdarstellung von dem Teil und einem Trägerteil der Prüfstiftvorrichtung,
- Figur 5: eine weitere perspektivische Längsschnittdarstellung der Prüfstiftvorrichtung,
- Figur 6: eine Querschnittsdarstellung der Prüfstiftvorrichtung,
- Figuren 7A und B: unterschiedliche Montagemöglichkeiten der Prüfstiftvorrichtung,
- Figur 8: eine vorteilhafte Weiterbildung der Prüfstiftvorrichtung in einer perspektivischen Darstellung, und
- Figur 9: eine vergrößerte Längsschnittdarstellung der Prüfstiftvorrichtung

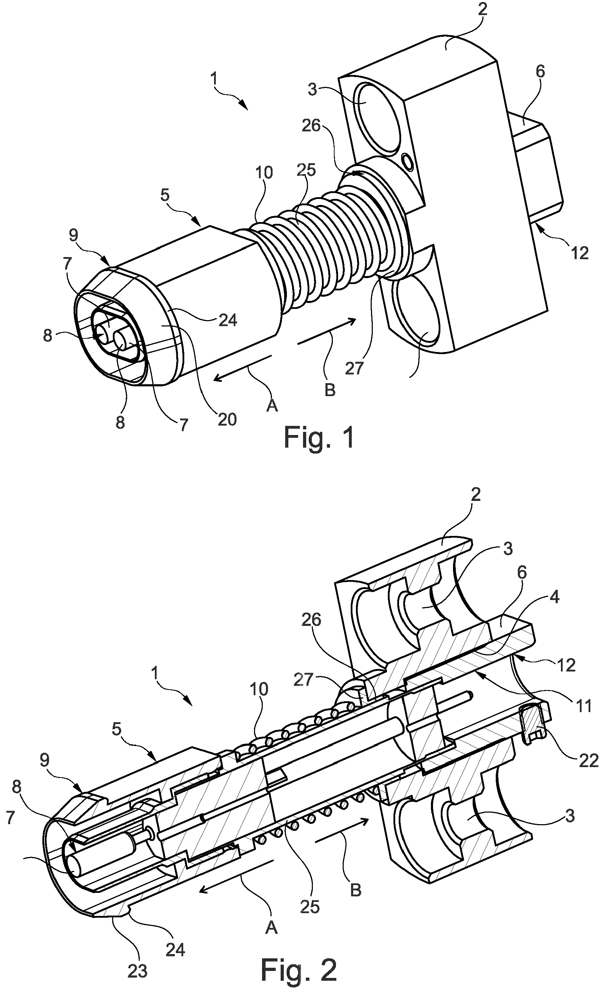

**Figur 1** zeigt in einer perspektivischen Darstellung eine Prüfstiftvorrichtung 1, die dazu ausgebildet ist, einen Kontaktpartner elektrisch zu kontaktieren. Bei dem Kontaktpartner handelt es sich beispielsweise um eine Leiterplatte oder eine andere Art von elektrischen/elektronischen Prüfling, der auf seine Funktionsfähigkeit geprüft werden soll. Mittels der Prüfstiftvorrichtung 1 ist der Kontaktpartner durch Berührungskontakt elektrisch kontaktierbar, sodass durch den Kontaktpartner beispielsweise ein Strom geleitet oder eine Spannung elektrisch an den Prüfling angelegt werden kann, um dessen Funktionsfähigkeit zu testen.

Damit eine sicherer Berührungsvorgang durchgeführt werden kann, bei welchem insbesondere Positionstoleranzen von Kontaktpartner zu Prüfstiftvorrichtung 1 ausglichen werden können, sieht die vorliegend beschriebene Prüfstiftvorrichtung 1 vor, dass sie bereichsweise drehbar und verschwenkbar ausgebildet ist. **Figur 2** zeigt hierzu die Prüfstiftvorrichtung 1 in einer perspektivischen Längsschnittdarstellung.

Die Prüfstiftvorrichtung 1 weist ein Trägerteil 2 auf, dass zwei Befestigungsöffnungen 3 aufweist, mittels welcher das Trägerteil 2 beispielsweise an einem Hauptträger befestigbar, insbesondere verschraubbar ist. Zwischen den Befestigungsöffnungen 3 weist das Trägerteil 2 eine Führungsöffnung 4 auf. In dieser Führungsöffnung 4 ist ein Prüfstift 5 längsverschieblich gelagert. Der Prüfstift 5 weist ein mehrteiliges Gehäuse 6 auf, in welchem gemäß dem vorliegenden Ausführungsbeispiel zwei stiftförmige Kontaktelemente 7 angeordnet sind. Insbesondere sind die Kontaktelemente 7 als Federkontaktstifte ausgebildet. Gemäß dem vorliegenden Ausgangsbeispiel weisen die Kontaktelemente 7 ein Kontaktende 8 auf, das als weiblicher Kontaktstecker zur Aufnahme eines männlichen Kontaktsteckers ausgebildet ist. Die Kontaktenden 8 liegen in einem Kontaktabschnitt 9 des Prüfstifts 5 beziehungsweise des Gehäuses 6. Das Kontaktende 9 ist entfernt von dem Trägerteil 2 angeordnet. Zwischen dem Kontaktende 9 und dem Trägerteil 2 ist ein Federelement 10, vorliegend eine Schraubenfeder, vorgespannt gehalten, die den Kontaktabschnitt 9 von dem Trägerteil 2 wegdrängt. Gemäß dem vorliegenden Ausgangsbeispiel ist die Schraubenfeder koaxial zu dem Gehäuse 6 zwischen dem Kontaktabschnitt 9 und dem Trägerteil 2 angeordnet.

Das Gehäuse 6 des Prüfstifts 5 weist weiterhin einen Führungsabschnitt 11 auf, der dazu dient, den Prüfstift 5 in der Führungsöffnung 4 des Trägerteils 2 zu lagern und zu führen. Auf den Führungsabschnitt 11 wird mit Bezug auf die folgenden Figuren noch näher eingegangen. An den Führungsabschnitt 11 schließt sich ein Axialanschlag 12 an, dessen Außenquerschnitt größer ist als der Querschnitt der Führungsöffnung 4, sodass das Gehäuse 6 mit dem Axialanschlag 12 auf der von dem Federelement 10 abgewandten Seite bis an das Trägerteil 2 heranschiebbar ist bis der Axialanschlag 12 auf das Trägerteil 2 trifft. Ein weiteres Verschieben des Prüfstifts 5 durch das Federelement 10 ist somit durch den Axialanschlag 6 verhindert. Der Prüfstift 5 ist somit zwischen Federelement 10 und Axialanschlag 12 an dem Trägerteil 2 gehalten. Durch die mehrteilige Ausbildung des Gehäuses 6 ist dabei eine einfache Montage des Prüfstifts 5 auf beiden Seiten des Trägerteils 2 gewährleistet, wobei zumindest der den Führungsabschnitt 11 aufweisende Gehäuseteil von der dem Federelement abgewandten Seite in das Trägerteil 2 eingeschoben werden muss.

Die Schraubenfeder drängt somit den Prüfstift in eine Ausgangsstellung gemäß Pfeil A, in welcher der Axialanschlag 12 an dem Trägerteil 2 anliegt. Wird ein Kontaktiervorgang durchgeführt, so wird der Prüfstift 5 mit dem Kontaktende 9 auf den Kontaktpartner gedrückt, wodurch der Prüfstift 5 entgegen der Federkraft in das Trägerteil 2 einfedern kann. Die Einfederrichtung ist in Figuren 1 und 2 durch einen Pfeil B angezeigt. Beim Einfedern wird der Führungsabschnitt 11 des Gehäuses 6 zumindest bereichsweise aus der Führungsöffnung 4 herausgeschoben.

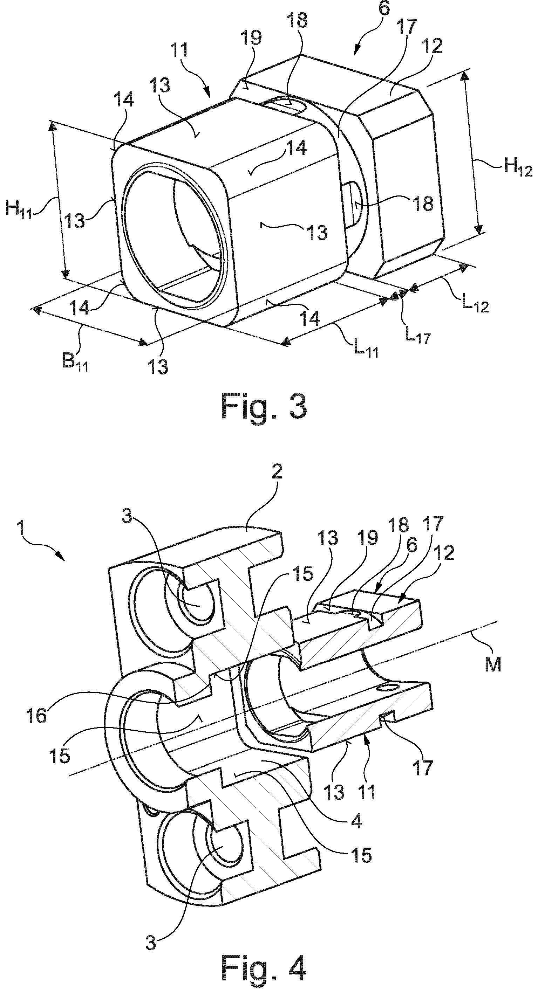

**Figur 3** zeigt den den Führungsabschnitt 11 aufweisenden Gehäuseteil des Gehäuses 6 in einer perspektivischen Darstellung. Der Führungsabschnitt 11 ist in Längserstreckung des Gehäuses 6 gesehen mit einem konstanten Querschnitt ausgebildet. Der Querschnitt ist dabei quadratisch ausgebildet, mit vier rechtwinklig zueinander angeordneten Geraden, sodass vier Führungsflächen 13 vorhanden sind, von denen jeweils die benachbarten senkrecht zueinander ausgerichtet sind. Dabei weist der Führungsabschnitt eine Höhe H₁₁ und eine Breite B₁₁, die gleich groß sind (H₁₁ = B₁₁), auf. Die Führungsflächen 13 enden im Querschnitt nicht direkt aneinander, stattdessen weist der quadratische Querschnitt an- oder abgefaste Ecken 14 auf, die jeweils zwischen den benachbarten Führungsflächen liegen. Alternativ sind die angefasten Ecken 14 als abgerundete Ecken ausgebildet.

Der Axialanschlag 12 weist einen Querschnitt auf, der der Form des Querschnitts des Führungsabschnitts 11 im Wesentlichen entspricht, jedoch insgesamt größer ausgebildet ist, insbesondere ist vorliegend seine Breite B₁₂ größer als seine Höhe H₁₂ (B₁₂ > H₁₂). Außerdem ist seine Breite B₁₂ größer als die Breite B₁₁ und die Höhe H₁₁ des Führungsabschnitts 11 (B₁₂ > B₁₂, H₁₁). Optional weist auch der Axialanschlag 12 einen quadratischen Querschnitt auf mit angefasten Ecken. In Längserstreckung gesehen ist der Axialanschlag 12 gemäß dem vorliegenden Ausführungsbeispiel kürzer ausgebildet als der Führungsabschnitt 11 (L₁₁ > L₁₂). Alternativ ist der Axialanschlag gleich lang oder länger als der Führungsabschnitt 11 ausgebildet. Dabei sind vorliegend der Führungsabschnitt 11 und der Axialanschlag 12 derart zueinander ausgerichtet, dass die Führungsflächen 13 parallel zu entsprechenden ebenen Flächen des Axialanschlags 12 ausgerichtet sind. Grundsätzlich kann der Axialanschlag 12 jeglichen Querschnitt aufweisen, solange der Axialanschlag 12 einen Querschnitt aufweist, der größer ist als der Querschnitt der Führungsöffnung 4, sodass gewährleistet ist, dass der Axialanschlag 12 zumindest bereichsweise eine Kraft in Längsverschiebungsrichtung auf das Trägerteil 2 ausüben kann. Grundsätzlich ist der Axialanschlag 12 im Querschnitt größer ausgebildet als der Führungsabschnitt 11 und auch größer als die Führungsöffnung 4, so dass der Axialanschlag 12 axial beziehungsweise an der Stirnseite des Trägerteils 2 anstoßen kann beziehungsweise im ausgefederten Zustand des Prüfstifts 5 anstößt. Umso größer Höhe H₁₂ und Breite B₁₂ des Axialanschlags 12 sind, desto größer ist die axiale Anschlagfläche, die mit dem Trägerteil 2 zusammenwirkt. Mit zunehmender Anschlagfläche 19 verbessert sich die Taumelzentrierung des Prüfstifts 5, wenn dieser durch das Federelement 10 in den ausgefederten Zustand gedrängt wird, in welchem der Axialanschlag 12 an dem Trägerteil 2 anliegt. Die Anschlagsfläche 19 des Axialanschlags 12 ist dabei zweckmäßiger Weise senkrecht zur Längserstreckung des Prüfstifts 5 ausgebildet, um eine planparallele Ausrichtung im Anschlagszustand zu gewährleisten, bei welcher der Prüfstift 5 beziehungsweise dessen Längsachse, insbesondere Mittellängsachse M oder eine außermittige Längsachse parallel zur Mittellängsachse, sich parallel zur Längsachse des Trägerteils 2 erstreckt. Der Axialanschlag 12 erzeugt bei nicht paralleler Lage der Anschlagfläche 19 zur Stirnfläche des Trägerteils 2 ein Kippmoment, welches den Prüfstift 5 beim Erreichen des Anschlags stets in die axial parallele Ausrichtung zwingt.

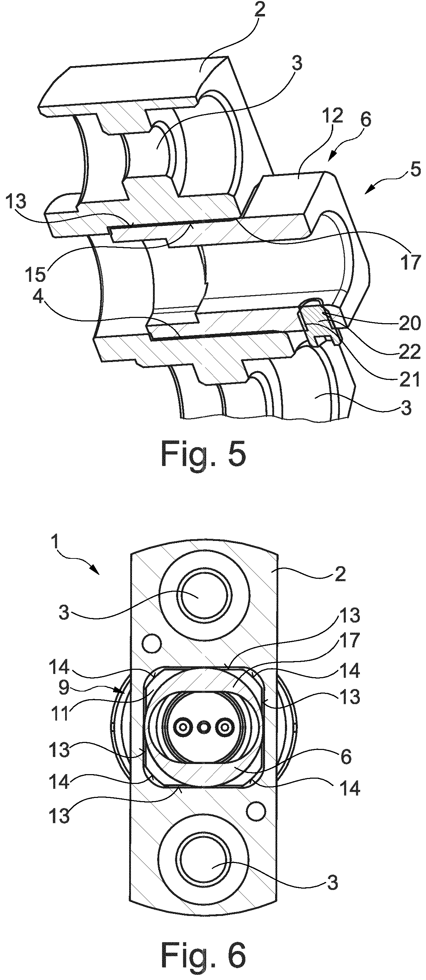

**Figur 4** zeigt eine perspektivische Längsschnittdarstellung, die einen Versatz zur Mittellängsachse M des Prüfstifts 5 aufweist, sodass die Schnittebene nicht durch die zentrale Mittellängsachse M verläuft, sondern radial versetzt dazu liegt. Die Führungsöffnung 4 weist einen zu dem Querschnitt des Führungsabschnitts 11 zumindest im Wesentlichen komplementären Querschnitt auf. So weist die Führungsöffnung 4 ebenfalls einen quadratischen Querschnitt auf. Wobei gemäß dem vorliegenden Ausführungsbeispiel und im Unterschied zu dem Querschnitt des Führungsabschnitts 11 die Ecken nicht angefast, sondern abgerundet sind. Die Breite und Höhe des quadratischen Querschnitts ist dabei nur geringfügig größer als die des Führungsabschnitts 11, wie beispielsweise auch in Figur 6 gezeigt, sodass der Führungsabschnitt 11 in der Führungsöffnung 4 verschleißarm verschiebbar gelagert ist. Dadurch, dass jeder der Führungsflächen 13 durch den quadratischen Querschnitt der Führungsöffnung 4 jeweils eine Führungsgegenfläche 15 zugeordnet ist, ist der Prüfstift 5 in der Führungsöffnung 4 vorteilhaft in Längsrichtung beziehungsweise axial verschiebbar. Durch die Größenunterschiede wird erreicht, dass das Gehäuse 6 in der Führungsöffnung 4 einerseits sicher geführt ist und andererseits sich um einen begrenzten Drehwinkel um die Mittellängsachse M relativ zu dem Trägerteil 2 verdrehen oder verkippen lässt. Dabei erfolgt ein Verkippen insbesondere um eine außermittige Längsachse des Prüfstifts, die parallel zur Mittellängsachse liegt. Desto kleiner die Größenunterschiede sind, desto geringer ist der maximale Drehwinkel. Unabhängig von seiner Größe ist der maximale Drehwinkel unabhängig von der Schiebestellung des Gehäuses 6 in dem Trägerteil 2 jedoch konstant.

An ihrem dem Federelement 11 zugewandten Ende weist die Führungsöffnung 4 eine Verjüngung in Form einer Stufe 16 auf, deren Innendurchmesser oder -querschnitt kleiner ist als der Außendurchmesser oder Querschnitt des Gehäuses 6 am Ende des Führungsabschnitts 11, sodass der Führungsabschnitt 11 nicht weiter als bis zu der Stufe 16 in Richtung des Pfeils A durch das Trägerteil 2 geschoben werden kann. Bevor jedoch der Führungsabschnitt 11 mit seinem freien Ende die Stufe 16 erreicht, schlägt der Axialanschlag 6 an dem Trägerteil 2 an. Dazu ist die Längserstreckung des Gehäuseteils von dem freien Ende des Führungsabschnitts 11 bis zu dem Axialanschlag 6 (L₁₁ + L₁₇) kleiner ausgebildet als die Tiefe oder Länge der Führungsöffnung 4 bis zu der Stufe 16.

Wie in **Figur 3** weiterhin gut zu erkennen ist, weist das Gehäuse 6 im Übergang von dem Führungsabschnitt 12 zu dem Axialanschlag 6 einen Übergangsabschnitt 17 auf. Im Vergleich zu der Axialerstreckung L₁₂ des Axialanschlags 12 und die Axialerstreckung L₁₁ beziehungsweise Länge des Führungsabschnitts 11 ist die Länge L₁₇ des Übergangsabschnitts 17 deutlich kürzer (L₁₇ << L₁₁, L₁₂) ausgebildet. In dem Übergangsabschnitt 17 weist das Gehäuse 6 einen kreisförmigen Querschnitt auf. Der Durchmesser der Kreisform ist dabei maximal so groß gewählt, wie die kleinste lichte Weite oder Diagonale im Querschnitt der Führungsöffnung 4, sodass der Übergangsabschnitt 17 in die Führungsöffnung 4 vollständig eingeschoben werden kann. Durch die Kreisform ist die Verdrehbarkeit des Gehäuses 6 in der Führungsöffnung 4 auch bei in die Führungsöffnung 4 eingeschobenen Übergangsabschnitt 17 unverändert, sodass die Kreisform ein Verdrehen des Gehäuses 6 in der Führungsöffnung 4 nicht behindert. Der in die Führungsöffnung 4 eingeschobene Übergangsabschnitt 17 bewirkt jedoch, dass der Prüfstift 5 in seiner Längserstreckung nicht mehr oder weniger stark relativ zu dem Trägerteil 2 verschwenkt werden kann. Der Übergangsabschnitt 17 begrenzt somit nur eine Taumelbewegung des Prüfstifts 5. Insoweit kann der Übergangsabschnitt 17 auch als Taumelzentrierung bezeichnet werden.

Vorzugsweise, und wie in den Figuren gezeigt, weist der Übergangsabschnitt 17 einen Durchmesser auf, der größer ist als Höhe oder Breite des quadratischen Querschnitts des Führungsabschnitts 11, sodass der Übergangsabschnitt 17 Führungsflächen 13 bereichsweise radial überragt. Ansonsten ist der Durchmesser des Übergangsabschnitts 17 kleiner gewählt als die größte Diagonale des Querschnitts des Führungsabschnitts 11, sodass in anderen Bereichen - in Umfangsrichtung gesehen - der Führungsabschnitt 11 den Übergangsabschnitt 17 überragt. Insbesondere im Bereich der angefasten Ecken 14 überragt der Führungsabschnitt 11 den Übergangsabschnitt 17 in radialer Richtung. Gemäß einem alternativen Ausführungsbeispiel, hier nicht dargestellt, wird der Führungsabschnitt 11 in dem Bereich, in welchem der Durchmesser des Übergangsabschnitts 17 kleiner ist als der Querschnitt des Führungsabschnitts 11, bis zu dem Axialanschlag 6 weitergeführt, sodass nur im Bereich der Führungsflächen 13 bereichsweise die Kreisform beziehungsweise Übergangsabschnitt 17 der Kreisform erkennbar und wirksam ist.

Um das Einführen des Übergangsabschnitts 17 in die Führungsöffnung 4 zu erleichtern, weist der Übergangsabschnitt im Bereich jeder der Führungsflächen 13 jeweils eine Einführschräge 18 auf, die von dem jeweiligen Führungsabschnitt 13 in Richtung des Außendurchmessers beziehungsweise Durchmessers des Übergangsabschnitts 17 führt. Die Einführschräge 18 steigt somit in Richtung des Axialanschlags 12 radial an. Dadurch erhält die jeweilige Einführschräge 18 eine Kreissegment-förmige Fläche. Beim Einführen des Übergangsabschnitts 17 in die Führungsöffnung 4 bewirken die Einführschrägen 18 eine Taumel-Zentrierung des Prüfstifts 5 relativ zu dem Trägerteil 2 durch welche das Taumeln des Prüfstifts 5 reduziert und der Prüfstift somit bezüglich seiner Taumelbewegung zentriert wird. Vorzugsweise weist der Übergangsabschnitt eine derartige Länge auf, so dass der Prüfstift 5 beim Ausfedern sicher ausgerichtet und zentriert wird, und so dass der Prüfstift nach einer ersten Kontaktierung des Kontaktpartners beim Einfedern schnell beziehungsweise nach einem kurzen Federweg eine Taumelbewegung ausführen kann. So weist dier Übergangsabschnitt 17 beispielsweise eine Axialerstreckung oder Länge von 0,05 mm bis 0,5 mm auf. Zusätzlich wird die Ausgangslage des Prüfstifts 5 in dem vollständig ausgefederten Zustand durch den Axialanschlag 12 unterstützt, der eine senkrecht zur Längserstreckung des Stifts 5 ausgerichtete Anschlagsfläche 19 aufweist, die im ausgefederten Zustand flächig an dem Trägerteil 2 anliegt, wie obenstehend bereits erläutert wurde.

Durch die vorteilhafte Ausbildung der Prüfstiftvorrichtung 1 wird also erreicht, dass der Prüfstift 5 in dem Lagerteil 2 bis zu einem maximalen Verdrehwinkel um seine Mittellängsachse M verdrehbar ist, und außerdem mit seiner Längsachse relativ zur Längsachse des Trägerteils 2 verschwenkt beziehungsweise taumeln kann. Die Taumelbewegung wird in der ausgefederten Ausgangsstellung mithilfe der Einführschräge 18 und dem Übergangsabschnitt 17 eingefangen, während die Drehbegrenzung über die gesamte Längsverschiebung des Prüfstifts 5 hinweg konstant bleibt.

**Figur 5** zeigt eine perspektivische Darstellung des den Führungsabschnitt 11 aufweisenden Gehäuseteils des Gehäuses 6 in dem Lagerteil 2 im ausgefederten Zustand. Hier ist jeweils zu erkennen, dass der Axialanschlag 6 die Führungsöffnung 4 überragt und dadurch mit der Axialanschlagsfläche 19 auf das Lagerteil 2 trifft, was ein weiteres Ausfedern verhindert. Außerdem zeigt Figur 5, dass der Übergangsabschnitt 17 in der Führungsöffnung 4 liegt.

Hierzu zeigt außerdem **Figur 6** in einer perspektivischen Querschnittsdarstellung, bei welcher die Schnittebene im Bereich des Übergangsabschnitts 17 liegt, dass durch die Kreisform, deren Durchmesser maximal der kleinsten Diagonalen des quadratischen Querschnitts der Führungsöffnung 4 entspricht, die Drehbarkeit des Prüfstifts 5 in der Führungsöffnung 4 nicht beeinträchtigt wird. Der maximale Drehwinkel wird also alleine durch die Führungsflächen 18 beziehungsweise die Querschnitte von Führungsabschnitt 11 und Führungsöffnung 4 definiert.

Optional weist die Prüfstiftvorrichtung 1 im Bereich des Axialanschlags 12 eine Querbohrung 20 in dem Gehäuse auf, die radial ausgerichtet ist. Insbesondere weist die Querbohrung 20 ein Gewinde 21 auf, in das eine Halteschraube 22, beispielsweise Madenschraube, wie in Figur 5 beispielhaft gezeigt, einschraubbar oder eingeschraubt ist, um Anschlusskabel, die in das Gehäuse 6 an dem von dem Kontaktabschnitt 9 abgewandten Ende des Gehäuses 6 eingeschoben sind, um die Kontaktelemente 8 elektrisch zu kontaktieren, festzuklemmen, um eine Zugentlastung für die Kontaktstellen zu gewährleisten.

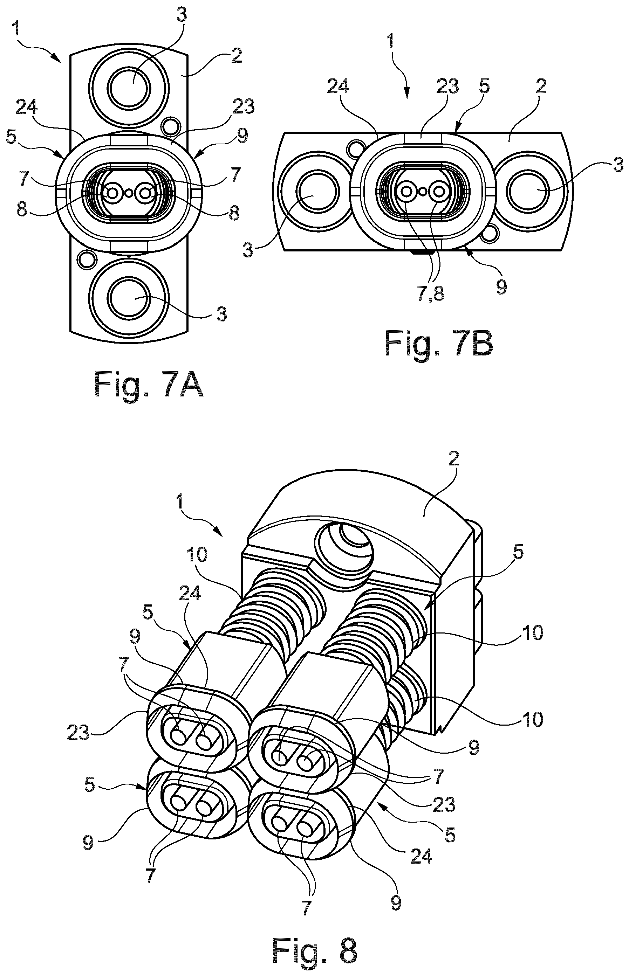

Die vorteilhafte Ausbildung des Führungsabschnitts und der Führungsöffnung mit jeweils quadratischem Querschnitt erlaubt es, den Prüfstift 5 in unterschiedlichen Drehstellungen, um jeweils 90 Grad versetzt, in das Trägerteil 2 einzusetzen. **Figuren 7A und B** zeigen dazu unterschiedliche Montagepositionen für den Prüfstift 5 an dem Trägerteil 2, die um 90 Grad verdreht zueinander liegen. Dadurch ist eine einfache Anpassung der Prüfstiftvorrichtung 1 an unterschiedliche Kontaktpartner oder Randbedingungen gewährleistet. Vorzugsweise ist der Kontaktabschnitt 9 maßgeblich für die Dimensionierung des Lagerteils 2. So ist bevorzugt vorgesehen, dass die Breite des Lagerteils 2, wie in Figuren 7A und B gezeigt, nicht breiter ist als die Breite des Kontaktendes 9.

**Figur 8** zeigt ein weiteres Ausführungsbeispiel der Prüfstiftvorrichtung 1, das sich von dem vorhergehenden Ausführungsbeispiel dadurch unterscheidet, dass in dem Lagerteil 2 mehrere Führungsöffnungen 4 ausgebildet sind, wobei in jede der Führungsöffnungen 4 ein Prüfstift 5 eingesetzt ist. Die Prüfstifte 5 und die Führungsöffnungen 4 sind wie obenstehend beschrieben ausgebildet. Dadurch kann in einem Lagerteil 2 eine Vielzahl von Prüfstiften 5 eingesetzt werden.

Vorteilhafterweise weist der jeweilige Kontaktabschnitt 9 des Prüfstifts 5 beziehungsweise des Gehäuses 6 außerdem eine Einführschräge 23 insbesondere an seiner Außenseite auf, um eine Zentrierung des Prüfstifts 5 zu dem Kontaktpartner bei dem Kontaktiervorgang zu bewirken. Die Einführschräge 23 bewirkt insbesondere einen weiten oder langen und sanften Einführbereich am Kontaktpartner sowie ein nahezu spielfreies Zentrieren am Innenbereich beziehungsweise an der Innenseite des Kontaktpartners. Gleichzeitig lassen die Außengeometrie sowie die Innengeometrie des Kontaktabschnitts 9 eine Achsverkippung (Taumeln) des Prüfstifts 5 zu, ohne dass die Bauteile gegeneinander verkanten. Hierzu ist vorgesehen, dass die Einführschräge 23 in einer Erhebung 24 endet, deren Querschnitt größer ist als der vom freien Ende des Kontaktabschnitts 9 abgewandte Mantelbereich des Gehäuses 6. Durch die Erhebung 24 ist ein schmaler oder linienförmiger Kontaktbereich zwischen dem Kontaktabschnitt 9 und der Innenseite des Kontaktpartners gewährleistet, sodass auch bei einer Taumelbewegung des Prüfstifts 5 ein Verkanten oder Verklemmen des Prüfstifts 5 in dem Kontaktpartner sicher verhindert ist. Vorzugsweise ist die Einführschräge 23 mit der Federkraft des Federelements 10 derart abgestimmt, dass das Einfedern und Taumeln des Prüfstifts 5 erst nach sicherer Kontaktierung des Kontaktpartners beginnt, ohne dass eine Beschädigung am Kontaktpartner auftritt.

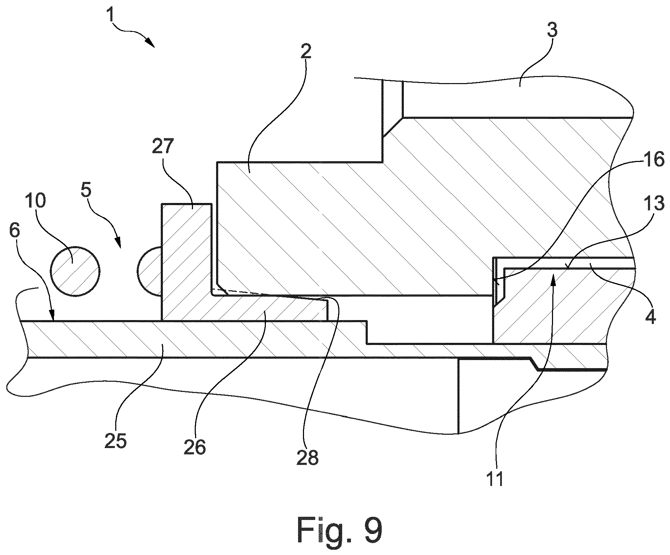

**Figur 9** zeigt in einer vergrößerten Längsschnittdarstellung die Prüfstiftvorrichtung 1 im Bereich des Trägerteils 2 auf der von dem Axialanschlag 12 abgewandten Seite. Das Gehäuse 6 weist in Weiterführung des Führungsabschnitts 11 einen Mantelabschnitt 25 auf, der in dem Trägerteil 2 radial spielfrei geführt ist. Dazu ist vorliegend zwischen dem Trägerteil 2 und dem Mantelabschnitt 25 im Bereich des querschnittverjüngten Abschnitts der Führungsöffnung 4, der die Stufe 16 bildet, ein Lagerring 26 angeordnet. Gleichwohl kann der Lagerring 26 auch in einer Führungsöffnung mit durchgehend konstantem Querschnitt eingesetzt werden. Vorzugsweise ist der verjüngte Querschnitt der Stufe 16 kreisförmig ausgebildet, so dass er keinen Einfluss auf eine mögliche Drehung des Prüfstifts 5 in der Führungsöffnung 4 hat. Der Lagerring 26 ist elastisch verformbar ausgebildet und radial zwischen Trägerteil 2 und Mantelwand 25 beziehungsweise Gehäuse 6 verspannt gehalten, sodass er elastisch verformt ist. Dazu ist beispielsweise der Außendurchmesser des Lagerrings 26 zumindest abschnittsweise geringfügig größer als der Innendurchmesser der Führungsöffnung 4 des Trägerteils 2 im Bereich der Stufe 16 und/oder sein Innendurchmesser ist geringfügig kleiner als der Mantelabschnitt 25 des Gehäuses 6, sodass in der montierten Position, wie in Figur 9 dargestellt, der Lagerring 26 radial elastisch verformt und dadurch vorgespannt beziehungsweise verspannt gehalten ist. Dabei ist der Lagerring 26 als Gleitring ausgebildet, so dass das Gehäuse 6 mit dem Mantelabschnitt 25 axial in dem Lagerring verschiebbar beziehungsweise gleitend gelagert ist, um das Ein- und Ausfedern des Prüfstifts 5 zu ermöglichen.

Der Lagerring 26 weist vorzugsweise einen radial vorstehenden Lagerringanschlag 27 auf, der die maximale axiale Eindringtiefe des Lagerrings 26 in das Trägerteil 2 begrenzt und der zwischen dem Trägerteil 2 und dem Federelement 10 derart liegt, dass sich das Federelement an dem Lagerringanschlag 27 axial abstützt. Vorzugsweise ist der Lagerringanschlag 27 einstückig mit dem Lagerring 26 ausgebildet. Besonders bevorzugt weist der Lagerring 26 eine Einführschräge 28 auf, die einen in Einführrichtung abnehmenden Außendurchmesser des Lagerrings 26 ausbildet. Insbesondere ist dazu der Lagerring 26 zumindest an der Mantelaußenwand konisch ausgebildet. Dabei erstreckt sich die Konusform des Lagerrings 26 bezeigungsweise die Einführschräge 28 im unverformten Zustand des Lagerrings 26, also beispielsweise vor der Montage, vorzugsweise von dem freien in das Trägerteil 2 einzuführenden Ende bis zu dem Lagerringanschlag 27, wie in Figur 9 durch eine gestrichelte Linie angezeigt. Durch das Federelement 10 beziehungsweise durch die von dem Federelement 10 bereitgestellte Vorspannkraft wird der Lagerring 26 axial in die Führungsöffnung 4 beziehungsweise in den verjüngten Abschnitt der Führungsöffnung 4 hineingedrückt, so dass dadurch der Lagerring 26 mit zunehmender Einschubtiefe elastisch verformt beziehungsweise verpresst wird. Optional kann dabei auch eine plastische Verformung des Lagerrings 26 stattfinden.

Durch die Verformung des Lagerrings 26 wird erreicht, dass der Prüfstift 5 mit dem Mantelabschnitt 25 spielfrei in dem Trägerteil 2 im Bereich der Stufe 16 geführt ist. Dadurch wird dem Prüfstift 5 im Bereich der Stufe 16 ein Taumellager beziehungsweise eine Lagerstelle geboten, durch welche eine Taumelachse für den Prüfstift 5 definiert wird, wobei die Taumelachse quer zur Längserstreckung des Prüfstifts 5 beziehungsweise Längsachse der Führungsöffnung 4 ausgerichtet ist. Zusammen mit dem Übergangsabschnitt 17 und dem Axialanschlag 12 wird durch den Lagerring 26 die Taumelbewegung des Prüfstifts 5 durch die verbesserte Längsführung relativ zu dem Trägerteil 2 optimiert. Mit zunehmendem Abstand von Lagerring 26 zu dem offenen Ende der Führungsöffnung 4, das dem Axialanschlag 12 zugewandt ist, wird die Führung des Prüfstifts 5 präziser und der zugelassene Taumelwinkel kleiner. Je nach Anwendungsfall ist daher ein bevorzugtes Verhältnis aus Abstand, Querschnittsform und Größe des Axialanschlags 12 sowie des Führungsabschnitts 11 und der Führungsöffnung 4 zu wählen, um kleinere oder größere Taumelbewegungen des Prüfstifts 5 relativ zu dem Trägerteil 2 zu ermöglichen.

Durch die Federkraftbeaufschlagung des Lagerrings 26 und dessen Einführschräge 28 ist außerdem gewährleistet, dass der Lagerring bei Verschleißerscheinungen automatisch weiter in das Trägerteil 4 hinein bewegt wird, um die spielfreie Lagerung aufrechtzuerhalten.

## Patentansprüche

1. Prüfstiftvorrichtung (1) zum elektrischen Kontaktieren eines insbesondere mehrpoligen Kontaktpartners, mit einem Trägerteil (2), das zumindest eine Führungsöffnung (4) aufweist, und mit zumindest einem Prüfstift (5), der in der Führungsöffnung (4) längsverschieblich gelagert ist, wobei der Prüfstift (5) ein zylinderförmiges Gehäuse (6) aufweist, in welchem ein oder mehrere insbesondere stiftförmige Kontaktelemente (7) angeordnet sind, die jeweils ein Kontaktende (8) zum Kontaktieren des Kontaktpartners aufweisen, wobei das Gehäuse (6) einen in der Führungsöffnung (4) längsverschieblich gelagerten Führungsabschnitt (11) und einen davon beabstandeten Kontaktabschnitt (9) aufweist, und wobei die Kontaktenden (8) dem Kontaktabschnitt (9) zugeordnet sind, wobei zwischen dem Kontaktabschnitt (9) und dem Trägerteil (2) ein Federelement (10) vorgespannt und an dem Gehäuse (6) an den Führungsabschnitt (11) anschließend, auf der von dem Federelement (10) abgewandten Seite des Trägerteils (2), ein Axialanschlag (12) ausgebildet ist, der mit dem Trägerteil (2) entgegen der Federkraft des Federelements (10) zusammenwirkt, wobei ein maximaler Dreh- und/oder Kippwinkel des Prüfstifts (5) um eine Längsachse relativ zu dem Trägerteil (2) durch die Führungsöffnung (4) und den Führungsabschnitt (11) begrenzt ist, wozu die Führungsöffnung (4) und der Führungsabschnitt (11) jeweils einen mehreckigen Querschnitt mit wenigstens einer Geraden aufweisen, und wobei Führungsabschnitt (11) und Führungsöffnung (4) derart ausgebildet sind, dass der Prüfstift (5) in zumindest einer Schiebeposition relativ zu dem Trägerteil (2) taumeln kann, **dadurch gekennzeichnet, dass** zwischen dem Führungsabschnitt (11) und dem Axialanschlag (12) ein Übergangsabschnitt (17) ausgebildet ist, dass der Übergangsabschnitt (17) einen kreisförmigen Querschnitt aufweist, dessen Durchmesser einerseits höchstens so groß wie die kleinste lichte Weite des Querschnitts der Führungsöffnung (4) und andererseits kleiner als die größte Diagonale und größer als die kleinste lichte Weite des Querschnitts des Führungsabschnitts (11) ist, so dass der Übergangsabschnitt (17) über seinen Umfang gesehen den Führungsabschnitt (11) nur bereichsweise radial überragt.

2. Prüfstiftvorrichtung nach Anspruch 1, **dadurch gekennzeichnet, dass** der Übergangsabschnitt (17) in zumindest einem den Führungsabschnitt (11) überragenden Bereich eine Einführschräge (18) aufweist.

3. Prüfstiftvorrichtung nach einem der vorhergehenden Ansprüche, **dadurch gekennzeichnet, dass** die Einführschräge (18) von dem Führungsabschnitt (11) in den Übergangsabschnitt (17) hinein ansteigend verläuft.

4. Prüfstiftvorrichtung nach einem der vorhergehenden Ansprüche, **dadurch gekennzeichnet, dass** der Führungsabschnitt (11) einen quadratischen Querschnitt aufweist.

5. Prüfstiftvorrichtung nach einem der vorhergehenden Ansprüche, **dadurch gekennzeichnet, dass** die Führungsöffnung (4) einen quadratischen Querschnitt aufweist.

6. Prüfstiftvorrichtung nach einem der vorhergehenden Ansprüche, **dadurch gekennzeichnet, dass** der Führungsabschnitt (11) im Querschnitt angefaste Ecken (14) aufweist.

7. Prüfstiftvorrichtung nach einem der vorhergehenden Ansprüche, **dadurch gekennzeichnet, dass** die Führungsöffnung (4) im Querschnitt abgerundete Ecken aufweist.

8. Prüfstiftvorrichtung nach einem der vorhergehenden Ansprüche, **dadurch gekennzeichnet, dass** der maximale Drehwinkel unabhängig von einer Längsverschiebung des Prüfstifts (5) in dem Trägerteil (2) begrenzt ist.

9. Prüfstiftvorrichtung nach einem der vorhergehenden Ansprüche, **dadurch gekennzeichnet, dass** die Führungsöffnung (4) an ihrem von dem Axialanschlag (12) abgewandten Ende eine den Querschnitt verjüngende Stufe (16) aufweist, und dass die Gesamtlänge von Führungsabschnitt (11) und Übergangsabschnitt (17) kleiner ist als der Abstand der Stufe (16) zum freien, dem Axialanschlag (12) zugewandten Ende der Führungsöffnung (4).

10. Prüfstiftvorrichtung nach einem der vorhergehenden Ansprüche, **dadurch gekennzeichnet, dass** das Gehäuse (6) im Bereich des Axialanschlags (12) eine Querbohrung (20) mit einem Gewinde (21) für eine Halteschraube (22) aufweist, mittels welcher Anschlusskabel in dem Gehäuse (6) befestigbar sind.

11. Prüfstiftvorrichtung nach einem der vorhergehenden Ansprüche, **dadurch gekennzeichnet, dass** der Kontaktabschnitt (9) des Gehäuses (6) an seinem freien Ende zumindest eine Einführschräge (23) zur Zentrierung an dem Kontaktpartner aufweist.

12. Prüfstiftvorrichtung nach einem der vorhergehenden Ansprüche, **dadurch gekennzeichnet, dass** das Kontaktende (8) des jeweiligen Kontaktelements (7) vollständig innerhalb des Gehäuses (6), insbesondere zurückgesetzt zu der freien Stirnseite des Kontaktabschnitts (9) liegt.

13. Prüfstiftvorrichtung nach einem der vorhergehenden Ansprüche, **dadurch gekennzeichnet, dass** das Trägerteil (2) eine oder mehrere Befestigungsöffnungen (3)beabstandet zu der Führungsöffnung (4) aufweist.

14. Prüfstiftvorrichtung nach einem der vorhergehenden Ansprüche, **dadurch gekennzeichnet, dass** das Trägerteil (2) mehrere Führungsöffnungen (4) aufweist in denen jeweils ein Prüfstift (5) montiert oder montierbar ist.

15. Prüfstiftvorrichtung nach einem der vorhergehenden Ansprüche, **dadurch gekennzeichnet, dass** das Trägerteil (2) eine Breite aufweist, die kleiner oder gleich der Breite des Kontaktabschnitts (9) ist.

16. Prüfstiftvorrichtung nach einem der vorhergehenden Ansprüche, **dadurch gekennzeichnet, dass** das Gehäuse (6) zwischen dem Führungsabschnitt (11) und dem Kontaktabschnitt (9) einen das eine oder die mehreren Kontaktelemente (7) umgebenden Mantelabschnitt (25) aufweist, der in dem Trägerteil (2), insbesondere in einem verjüngten Abschnitt der Führungsöffnung (4) radial geführt ist.

17. Prüfstiftvorrichtung nach Anspruch 16, **dadurch gekennzeichnet, dass** zur Führung ein Lagerring (26) vorhanden ist, der zumindest bereichsweise elastisch und/oder plastisch verformbar und zumindest abschnittsweise zwischen dem Mantelabschnitt (25) und dem Trägerteil (2) radial verspannt gehalten ist.

18. Prüfstiftvorrichtung nach einem der Ansprüche 16 und 17, **dadurch gekennzeichnet, dass** der Lagerring (26) eine Einführschräge (28) für das Trägerteil (2) aufweist und dazu insbesondere konisch ausgebildet ist.

19. Prüfstiftvorrichtung nach einem der Ansprüche 17 oder 18, **dadurch gekennzeichnet, dass** der Lagerring (26) einen radial vorstehenden Lagerringanschlag (27) aufweist, der axial zwischen dem Federelement (10) und dem Trägerteil (2) gehalten ist.

## Claims

1. Test probe device (1) for making electrical contact with an in particular multi-pole contact partner, with a carrier part (2), which comprises at least one guide opening (4), and with at least one test probe (5), which is longitudinally displaceably mounted in the guide opening (4), wherein the test probe (5) comprises a cylindrical housing (6) in which one or more in particular probe-shaped contact elements (7) are arranged, each of which comprises a contact end (8) for making contact with the contact partner, wherein the housing (6) comprises a guide portion (11) longitudinally displaceably mounted in the guide opening (4) and a contact portion (9) spaced apart therefrom, and wherein the contact ends (8) are assigned to the contact portion (9), wherein a spring element (10) is pretensioned between the contact portion (9) and the carrier part (2) and, adjoining the guide portion (11) at the housing (6), on the side of the carrier part (2) facing away from the spring element (10), an axial stop (12) is formed, which interacts with the carrier part (2) against the spring force of the spring element (10), wherein a maximum rotational and/or tilting angle of the test probe (5) is limited about a longitudinal axis relative to the carrier part (2) by the guide opening (4) and the guide portion (11), for the purpose of which the guide opening (4) and the guide portion (11) in each case comprise a polygonal cross section with at least one straight line, and wherein guide portion (11) and guide opening (4) are formed in such a way that the test probe (5) can tumble in at least one sliding position relative to the carrier part (2), **characterised in that** a transfer portion (17) is formed between the guide portion (11) and the axial stop (12), that the transfer portion (17) comprises a circular cross section, the diameter of which is at most as large as the smallest inner width of the cross section of the guide opening (4) on the one hand and smaller than the largest diagonal and larger than the smallest inner width of the cross section of the guide portion (11) on the other hand, so that the transfer portion (17), when viewed over its circumference, radially projects beyond the guide portion (11) only in some regions.

2. Test probe device according to claim 1, **characterised in that** the transfer portion (17) comprises a lead-in slope (18) in at least one region projecting beyond the guide portion (11).

3. Test probe device according to one of the preceding claims, **characterised in that** the lead-in slope (18) leads from the guide portion (11) so as to rise into the transfer portion (17).

4. Test probe device according to one of the preceding claims, **characterised in that** the guide portion (11) comprises a square cross section.

5. Test probe device according to one of the preceding claims, **characterised in that** the guide opening (4) comprises a square cross section.

6. Test probe device according to one of the preceding claims, **characterised in that** the guide portion (11) comprises corners (14), which are chamfered in the cross section.

7. Test probe device according to one of the preceding claims, **characterised in that** the guide opening (4) comprises corners, which are rounded in the cross section.

8. Test probe device according to one of the preceding claims, **characterised** the maximum angle of rotation is limited independently of a longitudinal displacement of the test probe (5) in the carrier part (2).

9. Test probe device according to one of the preceding claims, **characterised in that** the guide opening (4) comprises, on its end facing away from the axial stop (12), a step (16), which tapers the cross section, and that the total length of guide portion (11) and transfer portion (17) is smaller than the distance of the step (16) from the free end of the guide opening (4) facing the axial stop (12).

10. Test probe device according to one of the preceding claims, **characterised in that** the housing (6) comprises, in the region of the axial stop (12), a cross hole (20) with a thread (21) for a holding screw (22), by means of which connection cables can be fastened in the housing (6).

11. Test probe device according to one of the preceding claims, **characterised in that** the contact portion (9) of the housing (6) comprises, on its free end, at least one lead-in slope (23) for centering on the contact partner.

12. Test probe device according to one of the preceding claims, **characterised in that** the contact end (8) of the respective contact element (7) lies completely within the housing (6), in particular recessed from the free front side of the contact portion (9).

13. Test probe device according to one of the preceding claims, **characterised in that** the carrier part (2) comprises one or more fastening openings (3) spaced apart from the guide opening (4).

14. Test probe device according to one of the preceding claims, **characterised in that** the carrier part (2) comprises several guide openings (4), in which a test probe (5) is assembled or can be assembled in each case.

15. Test probe device according to one of the preceding claims, **characterised in that** the carrier part (2) comprises a width, which is smaller than or equal to the width of the contact portion (9).

16. Test probe device according to one of the preceding claims, **characterised in that** the housing (6) comprises, between the guide portion (11) and the contact potion (9), a jacket portion (25), which surrounds the one or the several contact elements (7) and which is guided radially in the carrier part (2), in particular in a tapered portion of the guide opening (4).

17. Test probe device according to claim 16, **characterised in that** for guidance purposes a bearing ring (26) is present, which is elastically and/or plastically deformable at least in some regions and which is held in a radially tensioned manner at least in some portions between the jacket portion (25) and the carrier part (2).

18. Test probe device according to one of claims 16 and 17, **characterised in that** the bearing ring (26) comprises a lead-in slope (28) for the carrier part (2) and is in particular formed conically for this purpose.

19. Test probe device according to one of claims 17 or 18, **characterised in that** the bearing ring (26) comprises a radially projecting bearing ring stop (27), which is held axially between the spring element (10) and the carrier part (2).

## Revendications

1. Dispositif de sonde de test (1) destiné à établir un contact électrique avec un partenaire de contact, en particulier multipolaire, comprenant une partie de support (2) qui présente au moins une ouverture de guidage (4), et au moins une sonde de test (5), qui est montée de manière à pouvoir coulisser longitudinalement dans l'ouverture de guidage (4), dans lequel la sonde de test (5) présente un boîtier cylindrique (6) dans lequel sont disposés un ou plusieurs éléments de contact (7), en particulier en forme de sondes, qui présentent chacun une extrémité de contact (8) pour entrer en contact avec le partenaire de contact, dans lequel le boîtier (6) présente une section de guidage (11) montée de manière à pouvoir coulisser longitudinalement dans l'ouverture de guidage (4) et une partie de contact (9) espacée par rapport à celle-ci, et dans lequel les extrémités de contact (8) sont associées à la partie de contact (9), un élément de ressort (10) précontraignant la partie de contact (9) et la partie de support (2) et, sur le côté de la partie de support (2) opposé à l'élément de ressort (10), à la suite de la section de guidage (11) du boîtier (6), est formée une butée axiale (12) qui interagit avec la partie de support (2) à l'encontre de la force du ressort de l'élément de ressort (10), dans lequel un angle maximal de rotation et/ou d'inclinaison de la sonde de test (5) autour d'un axe longitudinal par rapport à la partie de support (2) est limité par l'ouverture de guidage (4) et la section de guidage (11), l'ouverture de guidage (4) et la section de guidage (11) présentant chacune une section transversale polygonale comportant au moins une ligne droite, et dans lequel la section de guidage (11) et l'ouverture de guidage (4) sont conçues de telle sorte que la sonde de test (5) puisse osciller dans au moins une position de coulissement par rapport à la partie de support (2), **caractérisé en ce qu'**une section de transition (17) est formée entre la section de guidage (11) et la butée axiale (12), la section de transition (17) présente une section transversale circulaire dont le diamètre est, d'une part, au plus égal à la plus petite largeur intérieure de la section transversale de l'ouverture de guidage (4) et, d'autre part, est inférieur à la plus grande diagonale et supérieur à la plus petite largeur intérieure de la section transversale de la section de guidage (11), de sorte que la section de transition (17), vue sur sa circonférence, ne dépasse la section de guidage (11) radialement que par endroits.

2. Dispositif de sonde de test selon la revendication 1, **caractérisé en ce que** la section de transition (17) présente un chanfrein d'entrée (18) dans au moins une zone dépassant la section de guidage (11).

3. Dispositif de sonde de test selon l'une des revendications précédentes, **caractérisé en ce que** le chanfrein d'entrée (18) s'étend en pente ascendante depuis la section de guidage (11) vers la section de transition (17).

4. Dispositif de sonde de test selon l'une des revendications précédentes, **caractérisé en ce que** la section de guidage (11) présente une section transversale carrée.

5. Dispositif de sonde de test selon l'une des revendications précédentes, **caractérisé en ce que** l'ouverture de guidage (4) présente une section carrée.

6. Dispositif de sonde de test selon l'une des revendications précédentes, **caractérisé en ce que** la section de guidage (11) présente des angles chanfreinés (14) dans la section transversale.

7. Dispositif de sonde de test selon l'une des revendications précédentes, **caractérisé en ce que** l'ouverture de guidage (4) présente des angles arrondis dans la section transversale.

8. Dispositif de sonde de test selon l'une des revendications précédentes, **caractérisé en ce que** l'angle de rotation maximal est limité indépendamment de tout déplacement longitudinal de la sonde de test (5) dans la partie de support (2).

9. Dispositif de sonde de test selon l'une des revendications précédentes, **caractérisé en ce que** l'ouverture de guidage (4) présente, à son extrémité opposée à la butée axiale (12), un épaulement (16) dont la section transversale se rétrécit, et la longueur totale de la section de guidage (11) et de la section de transition (17) est inférieure à la distance entre l'épaulement (16) et l'extrémité libre de l'ouverture de guidage (4) tournée vers la butée axiale (12).

10. Dispositif de sonde de test selon l'une des revendications précédentes, **caractérisé en ce que** le boîtier (6) présente, au niveau de la butée axiale (12), un alésage transversal (20) muni d'un filetage (21) destiné à une vis de fixation (22), grâce à laquelle les câbles de raccordement peuvent être fixés dans le boîtier (6).

11. Dispositif de sonde de test selon l'une des revendications précédentes, **caractérisé en ce que** la partie de contact (9) du boîtier (6) présente, à son extrémité libre, au moins un chanfrein d'entrée (23) destiné à assurer le centrage sur le partenaire de contact.

12. Dispositif de sonde de test selon l'une des revendications précédentes, **caractérisé en ce que** l'extrémité de contact (8) de l'élément de contact (7) concerné se trouve entièrement à l'intérieur du boîtier (6), et plus particulièrement en retrait par rapport à la face frontale libre de la partie de contact (9).

13. Dispositif de sonde de test selon l'une des revendications précédentes, **caractérisé en ce que** la partie de support (2) présente une ou plusieurs ouvertures de fixation (3) espacées par rapport à l'ouverture de guidage (4).

14. Dispositif de sonde de test selon l'une des revendications précédentes, **caractérisé en ce que** la partie de support (2) présente plusieurs ouvertures de guidage (4) dans chacune desquelles une sonde de test (5) est montée ou peut être montée.

15. Dispositif de sonde de test selon l'une des revendications précédentes, **caractérisé en ce que** la partie de support (2) présente une largeur qui est inférieure ou égale à celle de la partie de contact (9).

16. Dispositif de sonde de test selon l'une des revendications précédentes, **caractérisé en ce que** le boîtier (6) présente, entre la section de guidage (11) et la partie de contact (9), une partie de gaine (25) qui entoure le ou les éléments de contact (7) et qui est guidée radialement dans la partie de support (2), en particulier dans une partie rétrécie de l'ouverture de guidage (4).

17. Dispositif de sonde de test selon la revendication 16, **caractérisé en ce qu'**un anneau de palier (26) est prévu pour le guidage, lequel est déformable élastiquement et/ou plastiquement au moins par endroit et est maintenu sous contrainte radiale au moins par section entre la partie de gaine (25) et la partie de support (2).

18. Dispositif de sonde de test selon la revendication 16 et 17, **caractérisé en ce que** l'anneau de palier (26) présente un chanfrein d'entrée (28) destiné à la partie de support (2) et est en particulier de forme conique à cet effet.

19. Dispositif de sonde de test selon la revendication 17 ou 18, **caractérisé en ce que** l'anneau de palier (26) présente une butée d'anneau de palier (27) faisant saillie radialement, qui est maintenue axialement entre l'élément de ressort (10) et la partie de support (2).
